# EUROPEAN PATENT APPLICATION

(11) **EP 4 730 652 A1**
(43) Date of publication of application: **22.04.2026**
(21) Application number: 24207775.8
(22) Date of filing: 21.10.2024
(51) Int. Cl.: H03K 17/082, H03K 17/16, H03K 17/08

(54) **CAPACITIVE CHARGING PROCESS**

(71) Applicant: Aptiv Technologies AG, 8200 Schaffhausen (CH)
(72) Inventor: HEINRICH, Markus, 51674 Wiehl (DE); TYPROWICZ, Wojciech, 34-113 Beczyn (PL); ROUMIER, Cyril, 17690 Angoulins (FR)
(74) Representative: Lewis Silkin LLP

(57) **Abstract**

A technique of charging a capacitive load is presented in which the load is charged by current pulses in a sequence of stages. The amplitude of the current pulses in each stage increases from one stage to the next. Transition between stages is triggered by the voltage across the load meeting a threshold requirement, until a target voltage is reached. The slew rate of a rising edge of each current pulse is lower than the sew rate of the falling edge.

## Description

### Field

The present disclosure relates to charging a capacitive load. Particularly, the present disclosure relates to a charging method and apparatus for controlling charging of a capacitive load in differently-configured charging phases, and to a charging system for charging the capacitive load using a metal-oxide-semiconductor field effect transistor, (MOSFET).

### Background

Many electrical loads are strongly capacitive, having the ability to store electric charge, and having an impedance which varies inversely with the frequency of an electric voltage across the load. During a turn-on phase of such capacitive loads, current is proportional to the speed the voltage is rising, and to the capacitance. Very high current is drawn from a charging apparatus as a result, and a switching element, such as a MOSFET, may be unable to survive the level of current that is drawn. In such circumstances, the current may pass straight through the load in the manner of a short circuit event.

Control logic associated with the charging apparatus may be unable to distinguish between scenarios in which the load is charging normally, albeit with high current, and scenarios in which the load is not charging at all due to such a short circuit event. The control logic may be configured such that if a short circuit event is perceived to have occurred, the charging apparatus is turned off and the load does not charge, and so normal charging may be prevented unnecessarily.

To mitigate this, a conventional charging apparatus for a capacitive load may include current limiting mechanisms, such as increasing the resistance of the charging path when the load is turned on, to reduce the likelihood of a short circuit event occurring. There is, however, a thermal penalty associated with such increased resistance, and where the current remains high, the charging apparatus may overheat and switch off. The charging apparatus is unable to resume charging of the load until it is has cooled sufficiently. This is particularly problematic where loads have high capacitances, as several cooling cycles may are required in order to enable charging to resume.

Embodiments of the present disclosure present a technique which aims to address such problems by avoiding the use of conventional current-limiting approaches.

### Summary

According to a first aspect, there is provided a method of charging a capacitive load, comprising: applying a first plurality of pulses of current to the capacitive load in a first charging phase; determining whether the capacitive load charges to a first predetermined voltage during the first charging phase; responsive to determining that the capacitive load charges to the first predetermined voltage, applying a second plurality of pulses of current to the capacitive load in a second charging phase; determining whether the capacitive load charges to a second predetermined voltage during the second charging phase; responsive to determining that the capacitive load charges to the second predetermined voltage, ending the second charging phase; wherein the amplitude of each pulse of the second plurality of pulses of current is higher than amplitude of each pulse of the first plurality of pulses of current, and the second predetermined voltage is higher than the first predetermined voltage; and wherein the slew rate of a rising edge of each of the first and second pluralities of pulses is lower than the slew rate of a falling edge of each of the first and second pluralities of pulses.

In this way, it is possible to detect if the charging process has begun under normal conditions, or if a short circuit is present, after a first charging phase has completed. If normal charging is occurring, inferred by the presence of sufficient voltage being maintained across the load, charging can continue in a second charging phase.

By enabling distinction between short circuit events and high-current charging, based on the voltage on the load, charging operations are not terminated unnecessarily. Further, it is not necessary to limit the resistance of the charging apparatus, as in the prior art, and so the problem of overheating is addressed.

In embodiments, the method further comprises applying further pulses of current to the capacitive load in one or more further charging phases after the second charging phase, wherein the amplitude of each further pulse of current is higher than the amplitude of each pulse of the second plurality of pulses of current. In this manner, it is possible to extend the charging process such that large capacitances can be charged using the same operating principle of the present disclosure.

In embodiments, responsive to determining that the capacitive load does not charge to the first predetermined voltage within a first predetermined time period, the method comprises ending charging of the capacitive load. In this manner, damage to the charging apparatus is prevented. A short circuit event can be inferred as a consequence of the load failing to charge as anticipated, and the charging process is ended to prevent continued supply of excessive current.

In embodiments, responsive to determining that the capacitive load falls below the first predetermined voltage during the second charging phase, the method comprises ending charging of the capacitive load. In this manner, determination of a short circuit event, or a charging failure, continues for the duration of the charging process.

In embodiments, the time period between pulses of the first plurality of pulses and the amplitude of the pulses of the first plurality of pulses are such that a charging device for applying the first plurality of pulses of current does not overheat in the first charging phase. In this manner, the disclosed technique is not restricted to determining whether or not a short circuit has occurred, but extends to taking steps to improve the charging process itself by preventing damage to the charging apparatus.

In embodiments, the current of the first and second pluralities of pulses is the drain-source current of a metal-oxide-semiconductor field-effect transistor, MOSFET, and the gate of the MOSFET is driven such that the drain outputs first and second pluralities of pulses of current.

In embodiments, the method further comprises turning the gate of the MOSFET off if a predetermined peak drain-source current is exceeded.

According to a second aspect, there is provided an apparatus for controlling charging of a capacitive load, the controller comprising: a driver arranged to drive a charging device to apply first plurality of pulses of current to the capacitive load in a first charging phase; a comparator arranged to determine whether the capacitive load charges to a first predetermined voltage during the first charging phase; the driver arranged to drive the charging device to apply second plurality of pulses of current to the capacitive load in a second charging phase in response to the comparator determining that the capacitive load charges to the first predetermined voltage; the comparator further arranged to determine whether the capacitive load charges to a second predetermined voltage during the second charging phase; the driver arranged to end the second charging phase in response to the comparator determining that the capacitive load charges to the second predetermined voltage; wherein the driver is arranged to drive the charging device such that: the amplitude of each pulse of the second plurality of pulses of current is higher than amplitude of each pulse of the first plurality of pulses of current, and the slew rate of a rising edge of each of the first and second pluralities of pulses is lower than the slew rate of a falling edge of each of the first and second pluralities of pulses; and wherein the second predetermined voltage is higher than the first predetermined voltage.

In embodiments, the driver is further arranged to drive the charging device to apply further pulses of current to the capacitive load in one or more further charging phases after the second charging phase, wherein the amplitude of each further pulse of current is higher than the amplitude of each pulse of the second plurality of pulses of current.

In embodiments, the driver is arranged to end charging of the capacitive load by the charging device in response to the comparator determining that the capacitive load does not charge to the first predetermined voltage within a first predetermined time period.

In embodiments, the driver is arranged to end charging of the capacitive load by the charging device in response to the comparator determining that the capacitive load does not fall below the first predetermined voltage during the second charging phase.

In embodiments, the time period between pulses of the first plurality of pulses and the amplitude of the pulses of the first plurality of pulses are such that the charging device does not overheat in the first charging phase.

In embodiments, the apparatus further comprises an interface for receiving a user selection of one or more of: a time period between each pulse of the first plurality of pulses; a time period between each pulse of the second plurality of pulses; the amplitude of each current pulse of the first plurality of pulses; the amplitude of each current pulse of the second plurality of pulses; the first and second predetermined voltages; a maximum permitted time period of the first and second charging phases after which the driver is operable to end charging of the capacitive load by the charging device; and the slew rate of the rising edge of each of the first and second pluralities of pulses.

In this manner, the charging process is fully configurable, and can be customised for use in charging particular loads.

According to a third aspect, there is provided a charging system comprising the apparatus of the second aspect, and the charging device, wherein the charging device is a metal-oxide-semiconductor field-effect transistor, MOSFET, and the driver is arranged to drive the gate of the MOSFET such that the drain outputs the first and second pluralities of pulses of current.

### Brief Description of Drawings

Illustrative embodiments will now be described with reference to the drawings in which:
Figure 1 shows a system for charging a capacitive load, according to embodiments of the present disclosure; and
Figure 2 shows a timing diagram for the charging current and voltage in a charging process according to embodiments of the present disclosure.

### Detailed Description

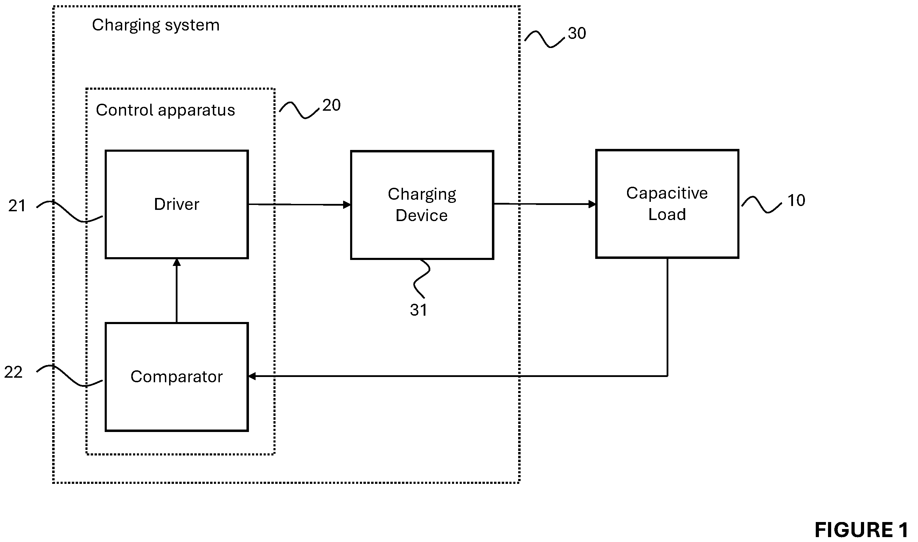

Embodiments of the present disclosure are described with reference to the system illustrated in Figure 1. Figure 1 shows a capacitive load 10 which is charged by current supplied by a charging device 31 contained within a charging system 30. In addition to the charging device 31, the charging system 30 comprises a control apparatus 20 for controlling the operation of the charging device 31, in accordance with embodiments of the present disclosure.

The control apparatus 20 comprises a driver 21 for driving the charging device 31, and a comparator 22 for comparing the voltage across the capacitive load 10 with a reference or threshold during a charging operation, and outputting a control instruction to the driver 21 which drives the charging device 31 accordingly.

In embodiments, the charging device 31 is a MOSFET, which outputs a charging current to the capacitive load 10. The driver 21 acts to output a control signal to the gate of the MOSFET, which drives the MOSFET accordingly, controlling the drain-source current with which the capacitive load 10 is charged. In alternative embodiments, other current sources may be employed instead of a MOSFET as the charging device 31.

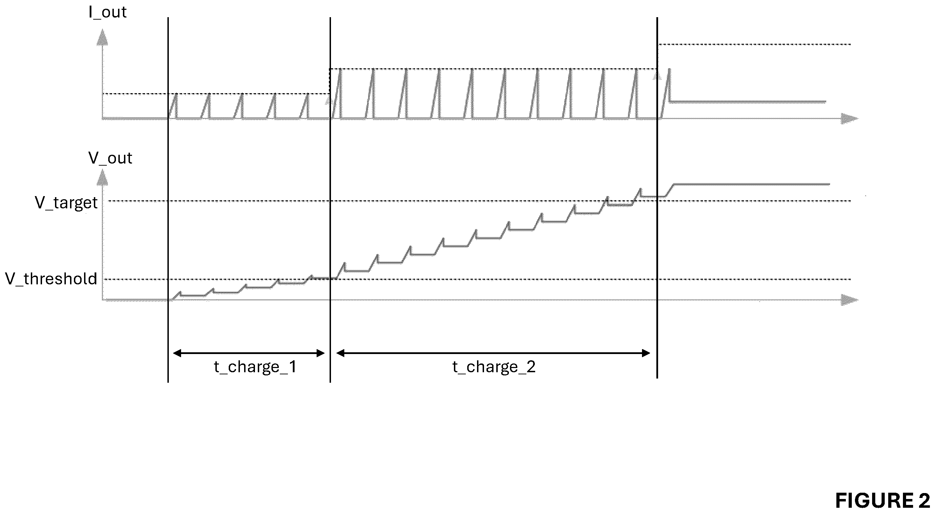

In embodiments, the driver 21 is arranged to control the charging device 31 to output pulses of current, the pulses defined in a manner described below with reference to Figure 2. The driver 21 applies periodic voltage pulses to the gate of the MOSFET of the charging device 31, such that the gate-source voltage periodically exceeds the threshold voltage of the MOSFET, turning the MOSFET on and causing output of charging current to the capacitive load 10. Between pulses, the control signal output by the driver 21 is at a low level such that the MOSFET switches off, turning off the charging current. In embodiments the MOSFET gate is turned off when the predetermined peak amplitude of the current pulse is reached. The current may be measured using any appropriate current-measurement arrangement, such as an instrumentation amplifier. The predetermined amplitude may be determined as a percentage of the maximum permitted drain-source current of the MOSFET. The MOSFET is switched back on after a predetermined waiting time.

Figure 2 illustrates a charging sequence according to embodiments of the present disclosure. Specifically, Figure 2 illustrates the charging current, I_out, which is output by the MOSFET to the capacitive load 10, and the voltage, V out which is maintained across the capacitive load 10. The aim of the charging sequence is to establish a target voltage, V_target, across the capacitive load 10.

The charging sequence of Figure 2 comprises two charging phases of duration t charge 1 and t charge 2, respectively. In the first charging phase, a first plurality of current pulses is output to the load 10. In the second charging phase, a second plurality of current pulses is output to the load 10. The amplitude of the pulses of the second plurality is greater than the amplitude of the pulses of the first plurality. The periodicity of the first and second pluralities of pulses is the same in the illustrated example, but this does not need to be the case.

The pulsed charging current causes relatively small incremental increases in the voltage which is established across the load 10. In this manner, the conventional difficulties associated with the low impedance turn-on phase can be avoided by restricting the amount at which the load 10 charges to small steps, repeating every 500µs or 1ms, for example. The use of periodic charging pulses prevents overheating of the charging device 31. The stepwise increase in the voltage V_out is illustrated in Figure 2. As each current pulse of the first plurality is applied, the voltage increases from its previous level, followed by a small drop in voltage associated with capacitive discharge of the load 10. The voltage stabilises to a new level in accordance with the charged from the current pulse which is stored as a result of the load's capacitance.

In the first phase, the control apparatus 20 primarily aims to determine whether the charging process is proceeding under normal conditions or if a short circuit is present, as a result of the turn-on phase mechanism described above. This is achieved by using the comparator 22 to monitor for the voltage V_out exceeding a threshold voltage, V_threshold. If V_threshold is exceeded, it is inferred that the load 10 has charged normally in the first charging phase, as it is able to maintain the threshold voltage, rather than the voltage dropping to zero as a result of a short circuit.

If V threshold is not exceeded within a predetermined charging time, it is inferred that a short circuit has occurred, and the charging operation is stopped by switching off the MOSFET.

If V_threshold is exceeded, the charging sequence moves to a second charging phase. In the second charging phase, a second plurality of current pulses is applied to the load 10. Each pulse of the second plurality has a higher peak current than the pulses of the first plurality, and accordingly, the height of each step of the stepwise increase in voltage across the load 10 is increased accordingly.

By increasing the peak current of the current pulses between the first charging phase and the second charging phase, the charging sequence can be accelerated in order to bring the load 10 towards V_target more quickly. The acceleration is justified, as the charging sequence has already confirmed that a short-circuit did not occur during the initial turn-on charging phase, and that the charging conditions are such that the load 10 is charging normally. The peak current is dependent on the nature of the charging device 31, which in turn depends on the load to be charged. Examples of representative currents are 5A to 50A in the first charging phase, which may be a nominal MOSFET current o multiple of the nominal current, and 20A to 90A in the second charging phase which may be a percentage (such as half, or three quarters) of the peak permitted drain-source current, with 100 pulses per phase, but any appropriate current levels and numbers of pulses may be used.

The comparator 22 determines whether the voltage across the load 10 has reached the target voltage, V_target and if so, the driver 21 switches off the control signal to the MOSFET to stop the charging process, with the load 10 fully charged. The ending of the charging process may occur immediately on detection by the comparator 22 of V target being reached, or may occur after a predetermined number of further current pulses of the second plurality have been applied to the load 10, to ensure that not only is V_target exceeded, but that a voltage exceeding V_target can be maintained for a predetermined period of time, rather than being a transient event. One such additional current pulse is illustrated in Figure 2 as occurring after the second charging phase has completed.

As with the first charging phase, a maximum time period may be set for the second charging phase, within which establishment of V_target should be achieved in order for normal charging to be confirmed. If V target is not met within this maximum time period, it is inferred that abnormal charging has occurred, and the charging sequence is stopped.

The total charging process is thus time-limited. In embodiments, the total duration is programmable and is set within a range of 10-200ms.

As shown in Figure 2, each current pulse, in each of the first and second charging phases, is asymmetrical in profile, with a lower turn-on slew rate than the turn-off slew rate. Figure 2 illustrates the lower gradient of the rising edge of each pulse than the gradient of the falling edge. The slew rate of the current pulses is affected at least partially by the slew rate of the gate voltage of the MOSFET. By limiting the predetermined turn-on slew rate by controlling the slew-rate of the gate voltage of the MOSFET, the impedance of the load 10 can be increased such that an excessively low impedance, and short circuit or abnormal charging events, are avoided, and the amount of charge stored by the load 10 is increased. Typical gate voltage slew rates may be limited to 0.5V/µs, and in some embodiments, as low as 0.05V/µs. For turn-off, any overheating can be avoided by turning off the current pulses as quickly as possible.

The comparator 22 is implemented using any conventional means for comparing a voltage against a threshold, such as a controller employing an analogue-to-digital converter, or an operational amplifier. The comparator 22 is connected to terminals of the load 10.

The driver 21 may be implemented using one or more processors executing computer-readable instructions, or programmable logic for a control algorithm defining the circumstances in which a particular control signal should be applied to the charging device 31. In embodiments, the driver 21 and comparator 22 are integrated as s single apparatus, having the control features required of the control apparatus 20.

The driver 21 may comprise a user interface (not shown) through which adjustments to the control algorithm can be made.

Adjustable parameters of the control algorithm include a time period between each pulse of the first plurality of pulses, a time period between each pulse of the second plurality of pulses, the peak current amplitude of each pulse of the first and second pluralities of pulses, V threshold, V target, and the maximum permitted time periods of the first and second charging phases after which the driver 21 is operable to end charging of the load 10 by the charging device 31. Additionally, the rising slew rate of the first and second pluralities of pulses can be set. In the case of a MOSFET as the charging device, if the rate of change of gate voltage is too low, the MOSFET may overheat before the load 10 is charged. This overheating would be caused by the MOSFET remaining in linear operating mode for too long before the load 10 is charged. By lowering the slew rate, more charge can be delivered to the load 10 per pulse, based on increasing the time taken for the current pulse to reach peak current.

In the present disclosure, the time period between pulses may also be considered as a pulse repetition time. By defining the timing between pulses in this manner, rather than defining the duration or width of a particular current pulse, variations in the time taken for the current pulse to reach its peak current, for example if the capacitance is already charged sufficiently, do not affect the charging sequence. The MOSFET stays on as long as the peak current is not exceeded for each pulse.

The amplitude and spacing between current pulses is determined in dependence on the nature of the connection, for example a cable length, between the charging device 31 and the load 10. Parameters of the charging device, maximum current levels of a MOSFET, and power consumption, are input to the driver 21 so that appropriate control signal voltages can be determined and output.

For example, the time period between current pulses of the first charging phase, and their amplitude, are chosen such that the MOSFET does not overheat. The amplitude may represent a nominal peak current which is not sufficient to cause heating of any significance.

In embodiments, it is possible to adjust the definitions of charging current pulses dynamically, in response to charging behaviour during the charging sequence. For example, if a load 10 reaches V_threshold more quickly than expected, the peak current of the second plurality of pulses may be reduced from an initial setting, as a lower peak current may be sufficient to charge the load 10 in a required time.

In embodiments, advantage is taken of the relationship between the drain-source voltage of the MOSFET and the drain-source current in order to limit the power consumption of the MOSFET during charging. As the power consumption is derived from the current of the voltage and current in this manner, it is desirable to use lower predetermined peak drain-source currents in the first charging phase than the second charging phase. The drain-source voltage is high at the beginning of the charging sequence, and corresponds to, for example, a power supply of battery voltage for the charging device 31. The drain-source voltage decreases as the load 10 is charged, and so lower peak current is permitted in the first charging phase than in the second charging phase.

This can be achieved by appropriate control of the gate-source voltage of the MOSFET to control its operating region, based on a slew rate, pulse period, predetermined peak current, and charging time, defining an appropriate selection of a control signal by the driver 21.

Voltages V_threshold and V_target are provided to the comparator 22 to define the basis of the comparisons which are performed. In embodiments, V_threshold is a relatively low voltage, of the order of 2V-3V. By setting such a low threshold voltage, a short circuit can be identified very quickly, as a failure to establish even a low voltage will demonstrate a charging abnormality. V_target, and the maximum charging times may depend on the load 10 to be charged, and so parameters defining the load 10, such as its capacitance, can be similarly input to the driver 21 in order for the driver 21 to select or determined an appropriate charging sequence. Quick identification of a short circuit is desirable in order to prevent damage to the charging device 31 and other components.

It will therefore be appreciated that it is possible for the charging sequence to be customised for a particular load 10, and a particular charging device 31. In embodiments, it is possible to extend the charging sequence to include third, fourth, and further charging sequences, where required. This may be appropriate for loads of high capacitance, or those requiring large target voltages. As with the charging sequence of Figure 2, the peak amplitude of each current pulse in successive charging stages may be greater than peak amplitudes of the current pulses of the previous stage, such that the voltage across the load 10 rises gradually.

Embodiments of the present disclosure represent a non-current limited approach to charging a load, which may be particularly appropriate where charging devices, such as MOSFETs, are employed which have no thermal sensor to cause them to cut-off or trip when they overheat, such as conventional N-type FETs. The multi-phase charging sequence described herein is configured such that overheating does not occur.

In some embodiments, the control apparatus 20, or a charging system 30 employing the control apparatus 20 and the charging device 31, may be used in conjunction with other systems and components in an automotive electronics setup. For instance, the disclosed charging system and control may be integrated with other load management systems, power supply systems, or diagnostic systems. This integration may allow for more comprehensive and coordinated management of the loads, enhancing the overall performance and safety of the automotive electronics setup.

The use of a dedicated control apparatus 20 for a charging device 31, ensures that the overall charging process is managed efficiently and safely, even in scenarios where there is no wider external microcontroller support for the charging process, such as in a Limp Home scenario occurring during failure of, for example, an automotive controller. As described above, the control apparatus 20 manages the various phases of the charging process, adjusting current levels and voltage trip levels as needed, based on the progress of the charging process.

The control apparatus 20 may, in embodiments, be extended to include diagnostic capabilities that can enable analysis of a charging process, to identify potential issues, timely intervention and troubleshooting. The inclusion of a diagnostics module, either as a standalone unit, or as functionality with the control apparatus, integrated, for example with the driver 21 or comparator 22, may be accompanied by an interface alerting a user to a charging error, or successful completion of charging.

Although the control system 30 of embodiments of the present disclosure is described in connection with charging of a single load, the same principles apply to charging of multiple loads in parallel, via a plurality of respective charging devices, all controlled via a centralised driver 21, and receiving voltage measurements from a single comparator device 22.

## Claims

1. A method of charging a capacitive load, comprising:
applying a first plurality of pulses of current to the capacitive load in a first charging phase;
determining whether the capacitive load charges to a first predetermined voltage during the first charging phase;
responsive to determining that the capacitive load charges to the first predetermined voltage, applying a second plurality of pulses of current to the capacitive load in a second charging phase;
determining whether the capacitive load charges to a second predetermined voltage during the second charging phase;
responsive to determining that the capacitive load charges to the second predetermined voltage, ending the second charging phase;
wherein the amplitude of each pulse of the second plurality of pulses of current is higher than amplitude of each pulse of the first plurality of pulses of current, and the second predetermined voltage is higher than the first predetermined voltage; and
wherein the slew rate of a rising edge of each of the first and second pluralities of pulses is lower than the slew rate of a falling edge of each of the first and second pluralities of pulses.

2. A method according to claim 1, further comprising:
applying further pulses of current to the capacitive load in one or more further charging phases after the second charging phase, wherein the amplitude of each further pulse of current is higher than the amplitude of each pulse of the second plurality of pulses of current.

3. A method according to claim 1 or claim 2, wherein:
responsive to determining that the capacitive load does not charge to the first predetermined voltage within a first predetermined time period, ending charging of the capacitive load.

4. A method according to any one of claims 1 to 3, wherein:
responsive to determining that the capacitive load falls below the first predetermined voltage during the second charging phase, ending charging of the capacitive load.

5. A method according to any one of the preceding claims, wherein the time period between pulses of the first plurality of pulses and the amplitude of the pulses of the first plurality of pulses are such that a charging device for applying the first plurality of pulses of current does not overheat in the first charging phase.

6. A method according to any one of the preceding claims, wherein the current of the first and second pluralities of pulses is the drain-source current of a metal-oxide-semiconductor field-effect transistor, MOSFET, and the gate of the MOSFET is driven such that the drain outputs first and second pluralities of pulses of current.

7. A method according to claim 6, comprising turning the gate of the MOSFET off if a predetermined peak drain-source current is exceeded.

8. An apparatus for controlling charging of a capacitive load, the controller comprising:
a driver arranged to drive a charging device to apply first plurality of pulses of current to the capacitive load in a first charging phase;
a comparator arranged to determine whether the capacitive load charges to a first predetermined voltage during the first charging phase;
the driver arranged to drive the charging device to apply second plurality of pulses of current to the capacitive load in a second charging phase in response to the comparator determining that the capacitive load charges to the first predetermined voltage;
the comparator further arranged to determine whether the capacitive load charges to a second predetermined voltage during the second charging phase;
the driver arranged to end the second charging phase in response to the comparator determining that the capacitive load charges to the second predetermined voltage;
wherein the driver is arranged to drive the charging device such that:
the amplitude of each pulse of the second plurality of pulses of current is higher than amplitude of each pulse of the first plurality of pulses of current, and
the slew rate of a rising edge of each of the first and second pluralities of pulses is lower than the slew rate of a falling edge of each of the first and second pluralities of pulses; and
wherein the second predetermined voltage is higher than the first predetermined voltage.

9. An apparatus according to claim 8, wherein the driver is further arranged to drive the charging device to apply further pulses of current to the capacitive load in one or more further charging phases after the second charging phase, wherein the amplitude of each further pulse of current is higher than the amplitude of each pulse of the second plurality of pulses of current.

10. An apparatus according to claim 8 or claim 9, wherein the driver is arranged to end charging of the capacitive load by the charging device in response to the comparator determining that the capacitive load does not charge to the first predetermined voltage within a first predetermined time period.

11. An apparatus according to any one of claims 8 to 10, wherein the driver is arranged to end charging of the capacitive load by the charging device in response to the comparator determining that the capacitive load does not fall below the first predetermined voltage during the second charging phase.

12. An apparatus any one of the claims 8 to 11, wherein the time period between pulses of the first plurality of pulses and the amplitude of the pulses of the first plurality of pulses are such that the charging device does not overheat in the first charging phase.

13. An apparatus according to any one of claims 8 to 12, further comprising an interface for receiving a user selection of one or more of:
a time period between each pulse of the first plurality of pulses;
a time period between each pulse of the second plurality of pulses;
the amplitude of each pulse of the first plurality of pulses;
the amplitude of each pulse of the second plurality of pulses;
the first and second predetermined voltages;
a maximum permitted time period of the first and second charging phases after which the driver is operable to end charging of the capacitive load by the charging device; and
the slew rate of the rising edge of each of the first and second pluralities of pulses.

14. A charging system comprising the apparatus of any one of claims 8 to 13, and the charging device, wherein the charging device is a metal-oxide-semiconductor field-effect transistor, MOSFET, and the driver is arranged to drive the gate of the MOSFET such that the drain outputs the first and second pluralities of pulses of current.
